Europäisches Patentamt

European Patent Office

Office européen des brevets

(19)

(11) Numéro de publication: **0 005 396**
**B1**

(12) **FASCICULE DE BREVET EUROPEEN**

(45) Date de publication du fascicule du brevet: **21.04.82**

(51) Int. Cl.³: **H 03 B 7/14,** H 03 F 3/10, H 01 P 1/00

(21) Numéro de dépôt: **79400269.1**

(22) Date de dépôt: **25.04.79**

(54) Circuit hyperfréquence à cavité résonnante équipée de paires de diodes périphériques.

(30) Priorité: **03.05.78 FR 7813091**

(43) Date de publication de la demande:
**14.11.79 Bulletin 79/23**

(45) Mention de la délivrance du brevet:
**21.04.82 Bulletin 82/16**

(84) Etats contractants désignés:
**BE DE GB LU**

(56) Documents cités:
FR - A - 2 052 076
FR - A - 2 060 129
FR - A - 2 214 978
US - A - 4 034 314
US - A - 4 090 152

(73) Titulaire: **THOMSON-CSF**
**173, Boulevard Haussmann**
**F-75360 Paris Cedex 08 (FR)**

(72) Inventeur: **Diamand, Felix**
**"THOMSON-CSF" - SCPI 173, Bld Haussmann**
**F-75360 Paris Cedex 08 (FR)**
Inventeur: **Bourrabier, Guy**
**"THOMSON-CSF" - SCPI 173, Bld Haussmann**
**F-75360 Paris Cedex 08 (FR)**
Inventeur: **Antoine, Robert**
**"THOMSON-CSF" - SCPI 173, Bld Haussmann**
**F-75360 Paris Cedex 08 (FR)**

(74) Mandataire: **Giraud, Pierre et al,**
**THOMSON-CSF SCPI 173, bld Haussmann**
**F-75360 Paris Cedex 08 (FR)**

Courier Press, Leamington Spa, England.

### Circuit hyperfréquence à cavité résonnante équipée de paires de diodes périphériques

L'invention concerne un circuit capable de fonctionner en dispositif à résistance négative dans le domaine des ondes électromagnétiques de très haute fréquence (plus de 1 GHz) avec une puissance cumulant celles d'au moins une paire de diodes couplées à une cavité résonnante.

La demande de brevet français 2.214.978 décrit un circuit hyperfréquence du type comportant une cavité résonnante et une chambre excitatrice constituée toutes deux par des portions de cylindres de révolutions d'axes parallèles, communiquant entre elles, la chambre excitatrice comportant une diode oscillatrice unique.

La demande de brevet français 2.060.129 décrit un circuit hyperfréquence du type comportant une seule cavité dans laquelle sont montées tête-bêche des diodes oscillatrices reliées entre elles par des tronçons de lignes coaxiales dont les conducteurs périphériques sont constitués par les parois cylindriques de la cavité et les conducteurs centraux sont reliés à une tige orthogonale à ces conducteurs servant à amener la tension d'alimentation des diodes oscillatrices.

On a cherché, pour augmenter la puissance délivrée par le circuit, à doubler le nombre des diodes oscillatrices des chambres excitatrices, en disposant en outre plusieurs de ces chambres autour d'une même cavité résonnante centrale, en s'inspirant des dispositions des deux demandes de brevet précitées. Malheureusement le résultat obtenu dans ces conditions est le suivant. Le mode d'oscillation antisymétrique, seul utile pour délivrer de la puissance en haute fréquence à l'extérieur des cavités, par exemple en utilisant une sortie d'antenne coaxiale, est pratiquement inexistant par rapport au mode prépondérant d'oscillation sur le mode symétrique, inutilisable en pratique. On a donc cherché, comme dans la demande de brevet français 2.060.129, à placer en un point convenable une impédance dissipative en vue d'étouffer le mode d'oscillation indésirable.

L'invention donne deux modes de réalisation particuliers d'une telle impédance dissipative.

Le circuit hyperfréquence selon l'invention comporte une cavité résonnante et au moins une chambre excitatrice, constituée par des portions de cylindres de révolution d'axes parallèles, communiquant entre elles, chaque chambre excitatrice comportant deux diodes oscillatrices montées tête-bêche, reliées par des tronçons de lignes coaxiales dont les conducteurs périphériques sont constitués par les parois cylindriques de la chambre et dont les conducteurs centraux, disposés suivant l'axe de la chambre excitatrice, sont reliés à une tige orthogonale aux conducteurs centraux servant à amener la tension d'alimentation aux diodes oscillatrices. Le circuit comporte en outre des moyens favorisant le mode d'oscillation antisymétrique par rapport au mode d'oscillation symétrique des diodes, ces moyens étant constitués par une impédance dissipative de puissance haute fréquence placée sur le trajet de la tige amenant la tension de polarisation. Le circuit est caractérisé en ce que cette impédance dissipative est réalisé soit par un manchon isolant encastré dans une paroi de la chambre excitatrice et servant de retenue à un tampon en caoutchouc conducteur de l'électricité inséré dans la tige de polarisation, soit en entourant cette dernière, dans la traversée de la paroi de la chambre excitative, par un diélectrique présentant des pertes sensibles en hyperfréquence.

L'invention sera mieux comprise, et d'autres caractéristiques appraraîtront au moyen de la description qui suit, en se reportant aux dessins qui l'accompagnent, parmi lesquels:

— la figure 1 est une vue éclatée, représentant en perspective, de façon simplifiée, une cavité résonnante et une chambre cylindrique en communication avec elle, ainsi que deux bouchons munis chacun d'une diode, suivant un mode de réalisation de l'invention;

— la figure 2 donne deux coupes schématiques suivant deux plans perpendiculaires d'une réalisation de l'invention ne contenant qu'une seule paire de diodes;

— la figure 3 est une coupe détaillée d'une variante d'un élément de la réalisation de la figure 2;

— la figure 4 donne deux coupes schématiques, suivant deux plans perpendiculaires, d'un exemple de réalisation de l'invention comportant trois paires de diodes;

— la figure 5 représente en coupe une variante de la figure 3.

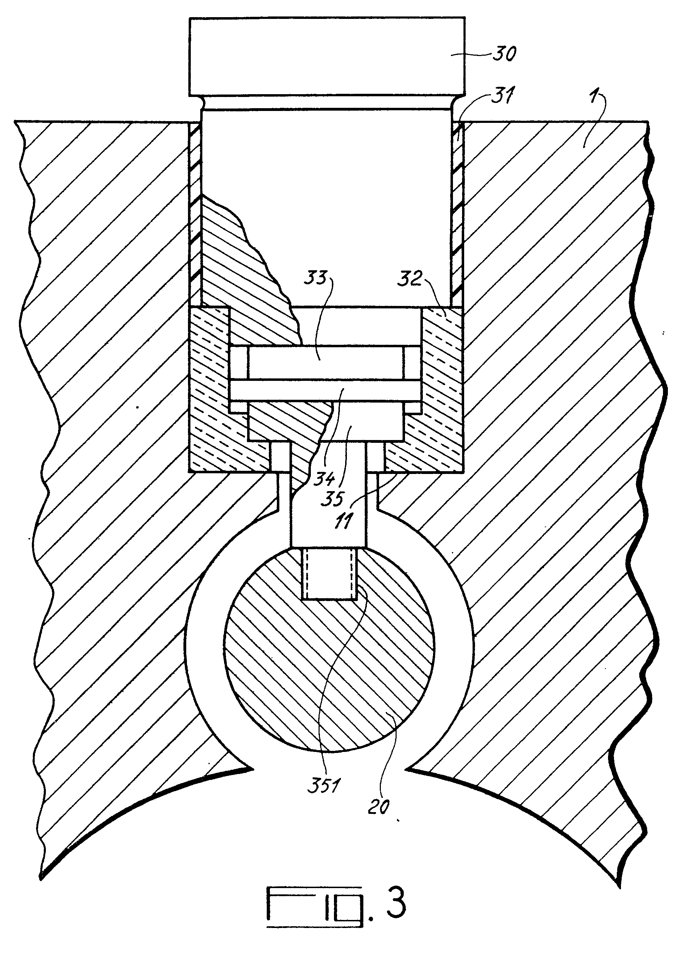

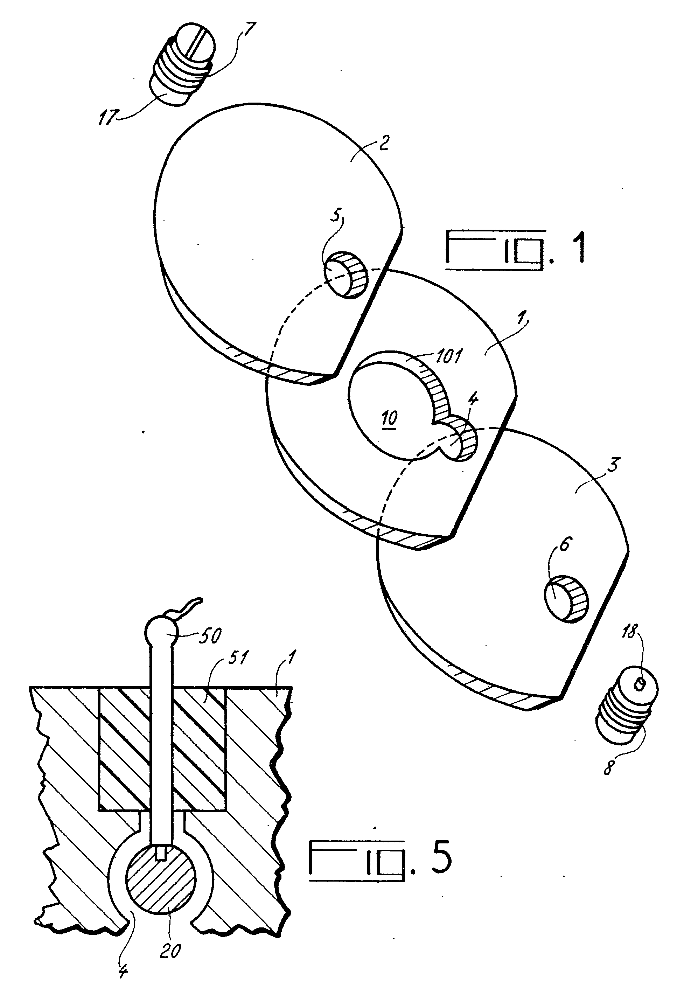

Pour faire apparaître aussi clairement que possible quelques caractéristiques principales de l'invention, on a représenté figure 1, cinq éléments d'un ensemble démontable définissant par leur assemblage la cavité centrale et une chambre latérale (ici unique) équipée de diodes.

Un bloc de cuivre 1, constituant l'élément central, comporte un orifice central 10 dont la paroi cylindrique définit le diamètre de la cavité résonnante et pratiquement la fréquence de fonctionnement du circuit; par exemple un diamètre de 14 mm pour une fréquence de 16 HGz. La paroi 101 s'ouvre sur une perforation 4 de diamètre inférieur à celui de l'orifice 10 qui communique ainsi avec l'orifice 4. L'épaisseur du bloc n'est pas imposée de façon rigoureuse et, dans l'exemple précité, peut être de 8 mm, ce qui définit la hauteur du cylindre constituant la cavité centrale.

Deux blocs analogues 2 et 3 ont les mêmes dimensions longitudinales, le même contour extérieur et une épaisseur un peu supérieure, par exemple 12 mm. Ils ne présentent pas de perforation centrale; le bloc 2 comporte un orifice 5 destiné à prolonger l'orifice 4, et symétrique ment, le bloc 3 comporte un orifice 6.

Les orifices 5 et 6 sont taraudés de manière à recevoir deux bouchons 7 et 8 portant un filetage correspondant au taraudage de ces orifices. Des diodes 17 et 18 sont soudées au centre de la face interne de chaque bouchon. On n'a pas représenté le système d'arrivée de la polarisation jusqu'à ces diodes.

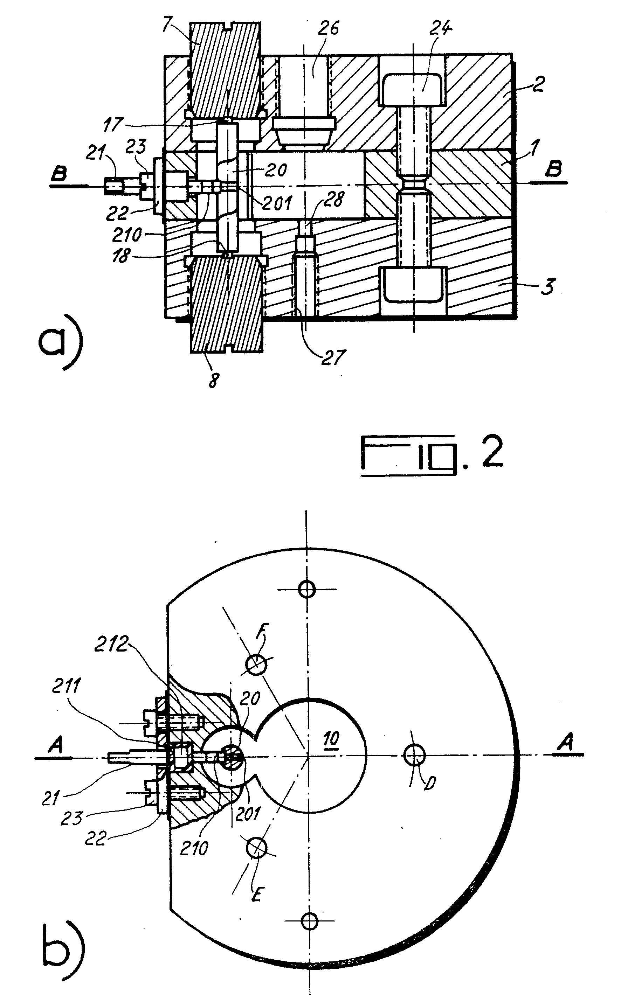

Figure 2, on a représenté en (a), une coupe schématique suivant un plan de trace AA sur la coupe (b); réciproquement, on a en (b) une coupe schématique suivant un plan de trace BB sur la coupe (a). On trouve ici assemblés les blocs 1, 2 et 3 déjà représentés Figure 1, ainsi que les bouchons 7 et 8, supportant les diodes 17 et 18. Ont été représentés en outre:

— le conducteur central de la chambre latérale formée par alignement des orifices 3, 4 et 5, ce conducteur étant matérialisé par un barreau 20 usiné en son centre pour recevoir l'extrémité 201 d'une tige 21 de polarisation qui assure la mise en place et le maintien du barreau 20 au contact des diodes 17 et 18;

— un dispositif d'entrée de polarisation comportant la tige 21 déjà mentionée, une bride 22 et des vis 23 fixées au bloc 1;

— une sortie 26 pour une antenne coaxiale (non représentée);

— une lumière 28 permettant l'introduction d'une tige de réglage diélectrique (non représentée), cette tige étant l'extrémité d'une vis isolante pénétrant dans un taraudage 27;

— des vis 24 assurant la cohésion des blocs 2 et 3 avec le bloc 1 aux trois sommets D, E et F d'un triangle équilatéral.

La tige 21 est interrompue par une résistance en silicium 210 destinée à étouffer un mode de fonctionnement parasite du circuit. Dans la réalisation de la figure 2, la tige 21 est maintenue enfoncée dans le bloc 1 par une bride 22 appuyant sur une collerette 212 de la tige 21, la collerette étant isolée par un revêtement isolant 211.

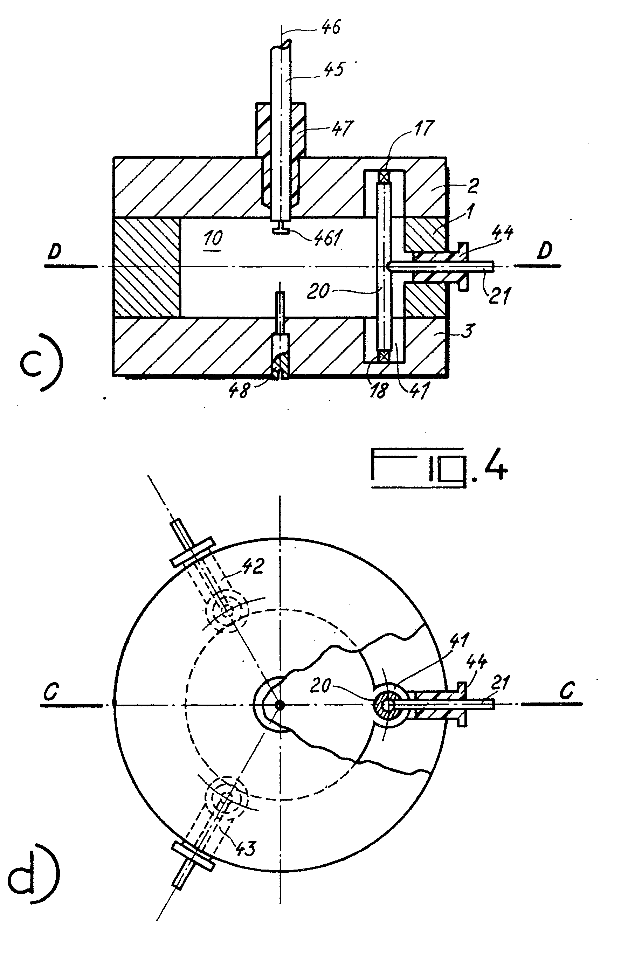

Figure 3, on a représenté une variante de réalisation de la tige de polarisation comportant deux parties en cuivre 30 et 35 séparées par un disque en silicium 33 et un tampon 34 en caoutchouc conducteur de l'électricité. L'isolement entre la tige et le bloc 1 est d'abord assuré par un premier manchon 31, par exemple en polytétrafluoréthylène, qui s'étend jusqu'à une certaine profondeur dans un logement adapté pratiqué dans le bloc 1. Ensuite, on trouve pour parfaire l'isolement et la tenue mécanique, un deuxième manchon 32, par exemple en alumine, retenu par une butée 11 du bloc 1. La partie 35 en cuivre de la tige de polarisation est usinée par diamètres décroissants jusqu'à une extrémité 351 portant un filetage destiné à permettre le vissage de l'extrémité 351 dans le barreau 20.

Un dispositif équivalent (en ce qui concerne l'atténuation en très haute fréquence) est représenté figure 5, où une tige de polarisation 50 est entourée dans la traversée du bloc 1 par un diélectrique chargé d'une substance résistive (par exemple de l'alumine "crackée" au carbone). Les pertes d'énergie ont lieu uniquement en haute fréquence sans affecter le courant continu ce qui permet d'obtenir un excellent rendement global du circuit.

Figure 4, on a représenté un circuit selon l'invention comportant trois paires de diodes placées dans des chambres latérales 41, 42 et 43, disposées à 120° l'une de l'autre sur un cercle concentrique à la cavité centrale 10. En (c), on a une coupe schématique selon un plan de trace CC sur la partie (d) de la figure 4, cette trace passant par l'axe de la tige de polarisation 21 de la chambre 41. On a simplifié le dessin en omettant de représenter les bouchons supports des diodes 17 et 18. Il en est de même pour la vue en plan figurant en Figure 4(d) en ce qui concerne les bouchons supports des diodes affectées aux chambres 42 et 43. Le dispositif d'arrivée de polarisation dans la chambre 41, seul visible en Figure 4(d) grâce à un arraché partiel, est réduit symboliquement à la tige 21 isolée par un manchon 44 et au barreau 20 portant le les diodes 17 et 18, représentées ici comme si elles étaient soudées à la masse des blocs 2 et 3 et non à leurs bouchons supports.

De façon simplifiée, on a représenté une sortie d'antenne coaxiale 45, isolée par un manchon 47; le conducteur central 46 du câble coaxial à diélectrique solide est mis à nu dans la partie du câble qui fait saillie dans la cavité 10. Un petit disque 461 est soudé à l'extrémité du conducteur 46 pour jouer le rôle de collecteur d'ondes dans la cavité. Enfin, une vis diélectrique 48 fait saillie dans la cavité à l'opposé de l'antenne coaxiale.

Parmi les paramètres importants du circuit de l'invention, on peut citer, outre le diamètre de la cavité principale:

— les dimensions du transformateur constitué par le conducteur 20 et de la chambre latérale dont il occupe l'axe, c'est-à-dire les longueurs et diamètre du cylindre dont il s'agit; les valeurs optimales de ces paramètres dépendent de l'impédance des diodes (aussi identiques que possible l'une à l'autre) équipant chaque chambre latérale; la détermination de ces dimensions peut être effectuée par le calcul et vérifiée expérimentalement;

— la valeur de la résistance 210, de l'ordre de quelques ohms;

Dans l'exemple décrit plus haut et représenté figure 2, les paramètres ont les valeurs ci-après:

— diamètre de la cavité principale: 14 mm;
— diamètre de la chambre latérale: 7 mm.

La résistance 210 a pour but de rendre évanescent le mode d'oscillation symétrique des diodes, en favorisant ainsi le mode anti-symétrique, seul utile pour transmettre de la puissance en haute fréquence à la sortie d'antenne coaxiale.

L'optimisation de la puissance de sortie de la source est fonction à la fois de la structure du transformateur et du couplage du collecteur d'ondes (enfoncement plus ou moins grand du conducteur 46 et du disque 461 figure 4c).

L'invention est applicable aux oscillateurs et amplificateurs en très haute fréquence notamment dans la bande de 5 à 20 GHz.

Dans ces applications, le dispositif oscillateur ou amplificateur constitué un dipôle à résistance négative monté par exemple aux borne d'un circulateur.

## Revendications

1. Circuit hyperfréquence comportant une cavité résonnante (10) et au moins une chambre excitatrice (4), constituée par des portions de cylindres de révolution d'axes parallèles, communiquant entre elles, chaque chambre excitatrice (4) comportant deux diodes oscillatrices (17, 18) montées tête-bêche, reliées par des tronçons de lignes coaxiales dont les conducteurs périphériques sont constitués par les parois cylindriques de la chambre (4) et dont les conducteurs centraux (20), disposés suivant l'axe de la chambre excitatrice (4) sont reliés à une tige (21) orthogonale aux conducteurs centraux (20) servant à amener la tension d'alimentation aux diodes oscillatrices (17, 18) le circuit comportant en outre des moyens favorisant le mode d'oscillation anti-symétrique des diodes, moyens constitués par une impédance dissipative de puissance haute fréquence placée sur le trajet de la tige (21) amenant la tension de polarisation, le circuit étant caractérisé en ce qu'il comporte un manchon isolant (31) encastré dans une paroi de la chambre excitatrice et servant de retenue à un tampon (34) en caoutchouc conducteur de l'électricité inséré dans la tige (21) de polarisation.

2. Circuit hyperfréquence comportant une cavité résonnante (10) et au moins une chambre excitatrice (4), constituée par des portions de cylindres de révolution d'axes parallèles, communiquant entre elles, chaque chambre excitatrice (4) comportant deux diodes (17, 18) oscillatrices montées tête-bêche, reliées par des tronçons de lignes coaxiales dont les conducteurs périphériques sont constitués par les parois cylindriques de la chambre (4) et dont les conducteurs centraux (20), disposés suivant l'axe de la chambre excitatrice (4) sont reliés à une tige (21) orthogonale aux conducteurs centraux (20) servant à amener la tension d'alimentation aux diodes oscillatrices (17, 18), le circuit comportant en outre des moyens favorisant le mode d'oscillation anti-symétrique par rapport au mode d'oscillation symétrique des diodes, moyens constitués par une impédance dissipative de puissance haute fréquence placée sur le trajet de la tige amenant la tension de polarisation, le circuit étant caractérisé en ce que la tige (50) de polatisation est entourée dans la traversée de la paroi de la chambre excitatrice (4) par un diélectrique (51) présentant des pertes sensibles en hyperfréquence.

3. Circuit suivant l'une des revendications précédentes, caractérisé en ce qu'il comporte trois chambres excitatrices (41, 42, 43) équipées chacune d'une paire de diodes (17, 18), centrées sur trois plans, passant par l'axe du cylindre principal, décalés mutuellement d'un angle de 120°, les trois chambres (41, 42, 43) communiquant avec la cavité (10).

## Patentansprüche

1. Höchstfrequenzschaltung mit einem Resonanzraum (10) und wenigstens einer Anregungskammer (4), die aus miteinander in Verbindung stehenden rotationssymmetrischen Zylinderteilen mit parallelen Achsen gebildet ist, wobei jede Anregungskammer (4) zwei Oszillatordioden (17, 18) umfaßt, die einander entgegengesetzt angeordnet und durch Koaxialleitungsabschnitte verbunden sind, deren Außenleiter durch die Zylinderwandungen der Kammer (4) gebildet sind, während ihre Innenleiter (20), die entlang der Achse der Anregungskammer (4) angeordnet sind, mit einer zu den Innenleitern (20) senkrechten Stange (21) verbunden sind, welche dazu dient, die Versorgungsspannung den Oszillatordioden (17, 18) zuzuführen, wobei die Schaltung ferner Mittel umfaßt, welche die antisymmetrische Schwingungsform der Dioden begünstigen und gebildet sind aus einer leistungsaufnehmenden Hochfrequenzimpedanz, die auf dem Weg der die Polarisationsspannung zuführenden Stange (21) angeordnet ist, wobei die Schaltung dadurch gekennzeichnet ist, daß sie eine isolierende Hülse (31) umfaßt, die eine Wandung der Anregungskammer eingesetzt ist und als Halterung für ein Kissen (34) aus elektrisch leitfähigem Gummi dient, welches in die Polarisationsstange (21) eingefügt ist.

2. Höchstfrequenzschaltung mit einem Resonanzraum (10) und wenigstens eine Anregungskammer (4), die gebildet ist aus miteinander verbundenen, rotationssymmetrischen Zylinderteilen, die parallele Achsen haben, wobei jede Anregungskammer (4) zwei einander entgegengesetzt angeordnete Oszillatordioden (17, 18) umfaßt, die durch Koaxialleitungsabschnitte verbunden sind, deren Außenleiter durch die zylindrischen Wandungen der Kammer (4) gebildet sind und deren Innenleiter (20), die entlang der Achse der Anregungskammer (4) angeordnet sind, mit einer zu den Innenleitern (20) senkrechten Stange (21) verbunden sind, die dazu dient, den Oszillatordioden (17, 18) die Versorgungsspannung zuzuführen, wobei die Schaltung ferner Mittel umfaßt, welche die in bezug auf die symmetrische Schwingungsform der Dioden antisymmetrische Schwingungsform begünstigen, wobei diese Mittel durch eine Hochfrequenz-Leistungsaufnahmeimpedanz gebildet sind, welche auf dem Weg der die Polarisationsspannung zuführenden Stange angeordnet ist, wobei die Schaltung dadurch gekennzeichnet ist, daß die Polarisationsstange (50) an der Durchführung durch die Wandung der Anregungskammer (4) von einem Dielektrikum (51) umgeben ist, das im Höchstfrequenzbereich beträchtliche Verluste aufweist.

3. Schaltung nach einem der vorstehenden Ansprüche, dadurch gekennzeichnet, daß sie drei Anregungskammern (41, 42, 43) umfaßt, von denen jede mit einem Diodenpaar (17, 18) ausgestattet ist und die auf drei durch die Achse des Hauptzylinders verlaufende, gegeneinander um einen Winkel von 120° versetzte Ebenen zentriert sind, wobei die drei Kammern (41, 42, 43) mit dem Hohlraum (10) in Verbindung sind.

## Claims

1. Hyperfrequency circuit comprising a resonance cavity (10) and at least one excitation chamber (4) formed by revolution cylinder sections having parallel axes and communicating with each other, each excitation chamber (4) comprising two oscillator diodes (17, 18) in opposed arrangement and connected by coaxial line sections the outer conductors of which are formed by the cylinder walls of the chamber (4) and the central conductors (20) of which are arranged along the axis of the excitation chamber (4) and connected to a rod (21) which is perpendicular to the center conductors (20) and is used to feed the supply voltage to the oscillator diodes (17, 18), the circuit further comprising means assisting the antisymmetrical oscillation mode of the diodes, said means being formed by a high frequency power dissipation impedance located on the path of the rod (21) feeding the polarizing voltage, the circuit being characterized in that it comprises an insulating sleeve (31) fitted into a wall of the excitation chamber and used to retain a pad (34) of rubber being electrically conductive and inserted into the polarizing rod (21).

2. Hyperfrequency circuit comprising a resonance cavity (10) and at least one excitation chamber (4) formed by revolution cylinder sections having parallel axes and communicating with each other, each excitation chamber (4) comprising two oscillator diodes (17, 18) in opposed arrangement and connected by coaxial line sections, the outer conductors of which are formed by the cylindrical walls of the chamber (4) and the center conductors (20) of which are arranged along the axis of the excitation chamber (4) and connected to a rod (21) perpendicular to the center conductors (20) and used to feed the supply voltage to the oscillator diodes (17, 18), the circuit further comprising means assisting the antisymmetrical oscillation mode with respect to the symmetrical oscillation mode of the diodes, said means being formed by a high frequency power dissipation impedance located on the path of the rod supplying the polarizing voltage, the circuit being characterized in that the polarising rod (50) is surrounded by a dielectric (51) having substantial hyperfrequency losses, on the passage through the wall of the excitation chamber (4).

3. Circuit in accordance with any of the preceding claims, characterized in that it comprises three excitation chamber (41, 42, 43) being each equipped with one pair of diodes (17, 18) and centered on three planes passing through the axis of the main cylinder and mutually shifted by an angle of 120°, the three chambers (41, 42, 43) communicating with the cavity (10).

FIG. 3

0 005 396

Fig. 1

Fig. 5

0 005 396

a)

Fig. 2

b)

FIG.4